# FASCICULE DE BREVET EUROPEEN

(11) **EP 0 688 051 B1**
(45) Date de publication et mention de la délivrance du brevet: **15.09.1999**
(21) Numéro de dépôt: 95201548.5
(22) Date de dépôt: 12.06.1995
(51) Int. Cl.: H01L 23/498, G06K 19/077

(54) **Procédé de fabrication et d'assemblage de carte à circuit intégré.**
Herstellungsverfahren und Montage für IC-Karte.
Fabrication process and assembly of an integrated circuit card.

(30) Priorité: 15.06.1994 FR 9407308
(43) Date de publication de la demande: 20.12.1995
(73) Titulaire: DE LA RUE CARTES ET SYSTEMES, 75013 Paris (FR)
(72) Inventeur: Launay, François, F-75008 Paris (FR); Venambre, Jacques, F-75008 Paris (FR)
(74) Mandataire: Barbin le Bourhis, Joel

(56) Documents cités:
- EP-A- 0 209 791
- EP-A- 0 226 480
- EP-A- 0 359 632
- DE-A- 3 535 791
- US-A- 5 081 520
- DATABASE WPI Week 9425 Derwent Publications Ltd., London, GB; AN 94-204146 & JP-A-06 140 743 (HITACHI CABLE)
- DATABASE WPI Week 9341 Derwent Publications Ltd., London, GB; AN 93-324501 & JP-A-05 235 511 (HITACHI CABLE)
- PATENT ABSTRACTS OF JAPAN vol. 15 no. 414 (M-1171) ,22 Octobre 1991 & JP-A-03 173696 (ASAHI CHEM)

## Description

L'invention concerne un procédé de fabrication et d'assemblage de carte électronique comportant un support de carte électriquement isolant muni d'un logement (ou cavité) pour recevoir un circuit intégré et, sur une face, des plages métalliques de contact reliées électriquement aux contacts dudit circuit intégré.

Le circuit intégré (ou puce), inséré dans le logement du support peut être une mémoire électronique, ou un microprocesseur, de surface plus grande que la simple mémoire.

Les procédés couramment employés pour la réalisation de cartes à puce électroniques utilisent un circuit imprimé déposé sur un film support, généralement en verre époxy, en polyimide ou en polyester, comme décrit par exemple dans le brevet européen EP 0 201 952 B1 au nom de la demanderesse (PHF 85/533). Il est aussi connu d'utiliser une grille surmoulée. Le film support ou la grille portent sur l'une des faces les plages métalliques de contact externe de la carte : l'autre face sert de support à la puce électronique qui est reliée électriquement aux contacts externes, à travers le film, ou la grille. Le matériau du film support et le matériau utilisé pour le surmoulage des grilles sont isolants afin d'isoler électriquement les contacts externes et les connexions internes de la puce électronique.

L'assemblage de la carte à puce consiste alors à :
- coller le circuit intégré (la puce) sur la face interne du film ou de la grille,
- réaliser les connexions électriques reliant les contacts de la puce aux plages métalliques de contacts externes (au moyen de fils conducteurs),
- protéger la puce et les connexions au moyen d'une résine de protection,
- découper le module électronique ainsi formé pour le détacher du film support ou de la grille,
- insérer et coller le module dans un support de carte en matière plastique (généralement du PVC, de l'ABS ou du polycarbonate) dans laquelle a été préalablement réalisé un logement (cavité) pour recevoir ledit module par son côté qui supporte le circuit intégré (la puce). Ce logement peut être réalisé par moulage par injection ou par lamage.

Avec ces procédés, l'opération de protection de la puce électronique et des connexions est souvent délicate car l'épaisseur de cette protection doit être parfaitement contrôlée pour permettre l'insertion dans la cavité du support de carte qui ne dépasse pas 650 µm de profondeur.

L'insertion du module électronique dans la carte est également délicate et exige des tolérances de planéité et de positionnement latéral très serrées pour éviter les problèmes d'utilisation dans les lecteurs, ou du logement dans la cavité.

Par ailleurs, le collage du module électronique doit être très efficace pour satisfaire les tests de torsion et de flexion imposés.

Enfin, ces procédés nécessitent l'emploi de film ou de grilles qui entrent pour une part importante dans le coût final du produit.

Les documents DE-A-3535791 et EP-A-0 209 791 montrent aussi l'assemblage de cartes électroniques.

Un but de la présente invention est de réduire le nombre d'étapes de procédé pour la fabrication et l'assemblage d'une carte à circuit intégré.

Un autre but est de s'affranchir de la fabrication d'un module intermédiaire, constitué par un film ou une grille supportant sur une face les plages métalliques de contact externe de la carte et sur l'autre face le circuit intégré.

Encore un autre but est de s'affranchir des contraintes de positionnement mécanique des plages métalliques de contact externe sur la carte.

Plus précisément l'invention concerne un procédé de fabrication et d'assemblage de carte électronique comportant un support plan électriquement isolant muni d'un logement pour recevoir un circuit intégré et, sur une face dudit support plan, de plages métalliques de contact reliées électriquement à des contacts du circuit intégré, caractérisé en ce qu'il consiste à :
- former dans ledit support un logement ouvert sur la face de celui-ci où sont définies lesdites plages métalliques de contact,
- former par une technologie dite MID en trois dimensions, des pistes électriquement conductrices s'étendant depuis ladite face dudit support jusqu'au fond dudit logement en s'étendant aussi le long des parois latérales de celui-ci, une telle piste étant reliée à une plage métallique précitée,
- mettre en place ledit circuit intégré dans ledit logement en le fixant au fond de celui-ci,
- connecter électriquement les contacts du circuit intégré aux extrémités des pistes conductrices s'étendant sur le fond dudit logement, et
- remplir ce dernier d'une résine de protection.

On obtient ainsi par suite d'opérations relativement simples et en nombre réduit, l'encapsulation du circuit intégré dans une carte souple normalisée quant à son format et à la position de ses plages métalliques de contact.

Selon un mode de réalisation préféré du procédé, l'étape d'application des pistes électriquement conductrices consiste en l'application par tampographie d'un catalyseur, selon la configuration désirée pour les pistes, suivie d'une métallisation par autocatalyse. De préférence, le support de carte est réalisé, avec son logement, selon une technique de moulage par injection et il peut comporter des surépaisseurs au fond du logement aux emplacements prévus pour les extrémités des pistes conductrices.

Pour ce qui est de la mise en place du circuit intégré dans le logement, ce dernier peut être collé, par sa base, au fond du logement, après quoi des fils conducteurs sont soudés chacun entre un contact du circuit intégré et une extrémité de piste conductrice, pour réaliser les connexions électriques.

Cependant, les modes de réalisation préférés, à cet égard, mettent en oeuvre la technique de montage flip-chip : selon une première variante, connue en soi, les connexions sont réalisées par soudure ou par colle conductrice en des points localisés, à l'endroit des contacts, et à cet effet, les contacts du circuit intégré sont munis de surépaisseurs conductrices, et aussi, généralement, les extrémités des pistes conductrices en vis-à-vis.

Un mode de réalisation préféré pour l'établissement des connexions électriques consiste en une technique de montage flip-chip du circuit intégré, lesdites connexions étant réalisées par collage, associé à une pression, au moyen d'une colle à conduction électrique anisotrope à l'état de film préformé ou de pâte, les contacts du circuit intégré étant démunis de surépaisseurs.

Dans cette variante, il est avantageux que la colle anisotrope soit prépolymérisée avant l'étape de réalisation des connexions électriques et que sa polymérisation finale soit effectuée en même temps que celle de ladite résine de protection.

La description qui suit en regard des dessins annexés, le tout donné à titre d'exemple non limitatif, fera bien comprendre comment l'invention peut être réalisée.

Les figures 1 et 2 représentent, vue en coupe et en plan respectivement, avec arrachement, une carte à circuit intégré pouvant être réalisée par le procédé selon l'invention.

La figure 3 montre en coupe la structure d'une piste conductrice munie de colle réactivable à chaud, utilisable dans le procédé selon l'invention.

Les figures 4A et 4B montrent, vue en perspective arrachée, la création de surépaisseurs aux extrémités des pistes conductrices.

La figure 5 représente, par une vue en coupe en partie arrachée, le détail d'un montage flip-chip préféré du circuit intégré par collage au moyen d'une colle à conduction anisotrope.

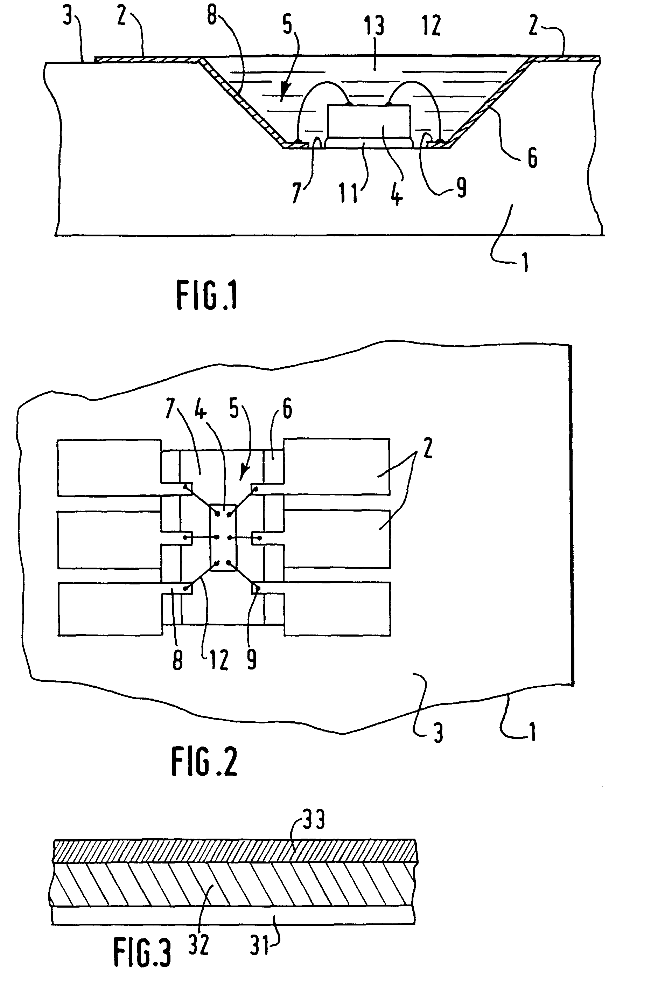

Aux figures 1 et 2 sont représentées les parties actives d'une carte à circuit intégré, où se trouvent les plages métalliques de contact destinées à coopérer avec les palpeurs d'un lecteur de carte. Le support de carte 1 comporte ces plages 2, de dimensions et de positionnement normalisés, sur une face 3 (dite supérieure) de la carte. Les plages métalliques sont, au moins pour certaines, reliées électriquement aux contacts d'un circuit intégré (ou puce) 4 qui est compris dans l'épaisseur du corps, ou support de carte 1.

Pour la mise en oeuvre du procédé selon l'invention, le support 1 comporte un logement 5 avec des parois latérales par exemple inclinées telles que 6 et dont le fond 7 est destiné à recevoir la puce de circuit intégré 4, et des pistes conductrices 8 (dites aussi lignes de métallisation) qui forment une continuité avec les plages 2, s'étendent de la face 3 du corps de carte, jusqu'au fond 7 du logement où se trouve leur extrémité libre 9 en passant sur les parois latérales du logement 1 qu'elles traversent. Le logement 5 doit avoir une profondeur inférieure à 650 µm afin de laisser une épaisseur de plastique suffisante en fond de carte pour éviter une cassure dudit fond de carte et protéger la puce électronique. Divers procédés peuvent être utilisés pour solidariser les pistes 8, essentiellement en cuivre, au support 1 qui est réalisé, avec son logement 5, de préférence par moulage par injection d'une matière thermoplastique telle que de l'ABS, ou du polycarbonate. Certains de ces procédés, préférés, sont décrits plus loin. Un choix est aussi possible entre plusieurs procédés pour la réalisation des connexions électriques reliant les contacts du circuit intégré mis en place dans le logement auxdites pistes conductrices au fond du logement. Celui, classique, représenté à la figure 1, consiste à monter le circuit intégré 4, collé par sa base au moyen d'une couche de colle polymérisable 11, généralement une colle époxy, au fond du logement 5, puis à souder des fils conducteurs 12, par exemple en or ou en aluminium, entre les contacts du circuit intégré 4 et les extrémités 9 des pistes conductrices. Divers procédés de montage et de câblage du circuit intégré sont bien conus de l'homme du métier et décrits dans de nombreuses publications, parmi lesquelles on peut citer les brevets FR 2 439 438, FR 2 548 857, EP 0 116 148, FR 2 520 541. Pour un tel montage, lorsque la base, nickelée, du circuit intégré constitue la masse, il est prévu qu'une extrémité de piste occupe la partie centrale du fond du logement (non représenté à la figure 1) et que cette base métallisée y soit collée au moyen d'une colle conductrice, par exemple une colle chargée à l'argent à raison de 70 % en volume. L'opération de collage peut être effectuée avec les colles et les équipements standards utilisés dans l'industrie des semiconducteurs (types KS, ESSEC ou autres). Le montage représenté à la figure 1 est celui pour lequel le circuit intégré possède tous ses contacts, y compris la masse sur une même face (la face supérieure à la figure 1).

Pour ce qui est du câblage par soudure de fils conducteurs, des fils d'or ou d'aluminium peuvent être utilisés, quoique le fil d'or soit préféré pour des questions de rapidité (le procédé thermosonique utilisé pour la soudure des fils d'or est 3 à 4 fois plus rapide que la soudure des fils d'aluminium). Cette opération est la plus délicate du procédé d'assemblage car elle nécessite un préchauffage du support plastique. Comme il n'est pas souhaitable que ce préchauffage excède la température de transition vitreuse Tg du support plastique (risque de déformation), il est préférable d'utiliser des cartes réalisées dans des matériaux à fort Tg (polycarbonate, ABS, composés ABS-PVC, ou composés ABS-polycarbonate).

Après montage et collage de la puce, l'opération de remplissage de la cavité 5 peut être réalisée par un procédé simple dit de potting en anglais et qui consiste en le dépôt d'une goutte de résine 13 dans la cavité 5. Afin d'obtenir une surface externe plane, on utilise de préférence des résines à très faible viscosité, telle par exemple la résine référencée 931-1 de la société américaine ABLESTICK. Cette résine doit posséder une haute pureté ionique et présenter une bonne résistance à l'absorption d'eau afin de protéger la puce électronique de façon efficace au cours des tests climatiques. Après application dans la cavité, la résine est polymérisée, ce qui constitue la dernière étape du procédé de fabrication et d'assemblage selon l'invention.

Les procédés préférés pour l'application des pistes conductrices 8 sur le support 1 sur une surface non plane, dite 3D, sont :
- l'emboutissage à chaud d'une configuration de pistes collables, dit Hot Foil Embossing en anglais,
- le procédé de tampographie, suivi d'une métallisation par autocatalyse,
- la réalisation de pistes par lithogravure obtenue à partir d'hologrammes laser.

Parmi ces trois procédés les deux premiers sont bien connus et éprouvés, assez économiques, mais ne permettent pas d'obtenir une grande résolution pour la réalisation des pistes. Lorsqu'une grande résolution est requise, le troisième procédé, plus précis, peut être utilisé.

Les techniques de tampographie et de lithogravure sont compatibles avec la création de surépaisseurs aux extrémités 9 des pistes conductrices, réalisées au fond du logement lors du moulage par injection du support 1.

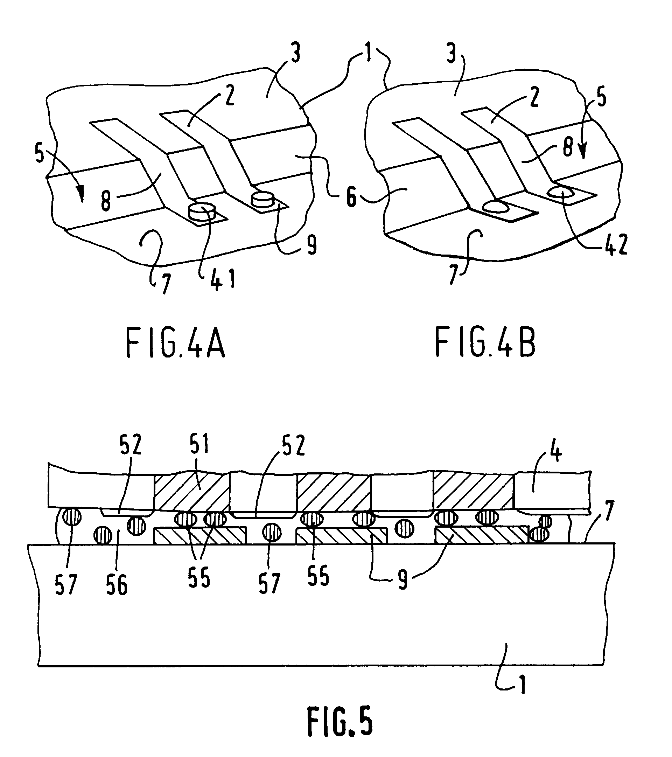

Concernant le procédé d'emboutissage (ou encore d'estampage) à chaud, on peut citer à titre d'exemple le contenu du brevet EP 0 063 347. Avec un cycle thermique d'une durée de l'ordre de 2 s, une configuration de pistes métalliques de 12 à 70 µm d'épaisseur peut être appliquée contre le support de carte, à l'endroit du logement 5 dont la forme est conçue à cet effet, c'est-à-dire avec parois inclinées de préférence, la pression d'application étant de l'ordre de 80 N/mm² et la température de l'ordre de 200°C. A cet effet, les feuilles d'estampage à chaud qui comportent les configurations de pistes ont la structure représentée à la figure 3 : une ou plusieurs couches de colle réactivable à chaud 31 (généralement à base de phénols) ayant une épaisseur de 1 à 4 µm, une couche de cuivre 32, assez ductile, d'épaisseur comprise entre 12 et 35 µm, et éventuellement une couche 33 d'étain ou de nickel de quelques µm d'épaisseur. La partie de la feuille qui n'est pas estampée peut ensuite être otée à partir d'une station d'enroulement avec du ruban adhésif.

Par le procédé de tampographie, avec une durée de cycle de 2 s, une laque contenant du palladium peut être imprimée contre le support de carte 1, contre les parois et le fond du logement 5 et autour de ce dernier sur la face 3, selon le dessin requis pour la configuration des pistes métalliques à créer à cet endroit. La qualité de l'impression est bonne, puisqu'il est ainsi possible d'obtenir une précision de l'ordre de 50 µm pour la largeur des pistes conductrices aussi bien que pour la distance de séparation entre pistes.

La laque contenant du Pd, qui constitue un catalyseur et qui est déposée aux endroits adéquats sur le support 1, est ensuite chauffée à 100°C. Puis une métallisation (cuivre ou nickel), par autocatalyse est effectuée, cette dernière opération étant depuis longtemps connue et maîtrisée : le cuivre (nickel) ne se dépose, sur le support 1, qu'aux endroits où du catalyseur est présent. L'épaisseur de cuivre déposé est comprise entre 1 et 10 µm. Le principal avantage de ce procédé électrochimique de métallisation est que plusieurs milliers à plusieurs dizaines de milliers de cartes peuvent être traitées en même temps, plongées ensemble dans un même bain, en l'espace de quelques heures.

Lorsqu'une plus grande précision est nécessaire, pour le dessin des pistes conductrices dans le logement 5, il est possible d'utiliser un procédé de photolithographie, plus coûteux que les précédents. Cette technique est la transposition de la technique de photolithographie classique, pour la métallisation de surfaces planes, à la métallisation de surfaces gauches, en l'occurrence les parois et le fond du logement 5 et ses abords immédiats sur la face 3 du support. Pour cela, une technique de mise au point par masques 3D ou hologramme laser a été élaborée, qui consiste à réaliser l'image des pistes en 3D sur une surface qui coïncide avec celle du logement, ce qui permet d'obtenir la polymérisation d'un vernis seulement aux endroits voulus sur la surface du logement.

Par exemple, un procédé semi additif peut être utilisé pour la réalisation des pistes. Ce procédé, actuellement utilisé dans les principaux pays développés, consiste à effectuer un traitement du support plastique pour améliorer l'adhérence d'un dépôt métallique, du cuivre de préférence, sur lequel on fait ensuite croître des couches de contacts électriques en utilisant un masque de photorésist. Après exposition, le masque et les couches autour des contacts sont éliminés. Ce procédé permet donc des métallisations sur des supports non plans en utilisant des masques 3D ou des techniques au laser (génération d'hologrammes), et procure une résolution de l'ordre de 50 µm. Au moyen des différents procédés de métallisation précités, les contacts électriques ne sont plus supportés par un film ou une grille, comme dans l'art antérieur, mais par le support de carte lui-même. De plus, les opérations de traversée d'un matériau isolant, pour l'établissement des contacts ne sont plus nécessaires.

Outre la technique de montage classique représentée à la figure 1 et lorsque le contact de masse est reporté sur la même face du circuit intégré que les autres contacts, ce qui est de plus en plus souvent le cas, une technique de montage flip-chip décrite ci-dessous est préférée. Pour cela, les extrémités 9 des pistes conductrices 8 peuvent comporter des surépaisseurs dont la configuration est symétrique (par rapport à un plan) de celle des contacts de la puce avec lesquels elles doivent coopérer. De telles surépaisseurs, représentées schématiquement aux figures 4A et 4B, sont réalisées de préférence lors du moulage du support de carte 1 : leur forme peut être cylindrique comme en 41, figure 4A, ou avoir l'aspect d'une calotte sphérique 42, figure 4B, et leur hauteur est de quelques dizaines de µm. La métallisation des surépaisseurs 41 ou 42 peut être effectuée en même temps que celle des pistes 8 par les procédés de tampographie ou lithogravure indiqués plus haut.

Selon des procédés connus, classiques, en technique de montage flip-chip, les contacts du circuit intégré, en aluminium doivent, préalablement au montage, être munis de surépaisseurs, en or ou en cuivre réalisées par dépôt galvanique, (ce qui implique une opération de reprise délicate du circuit intégré après sa fabrication) ou par soudure de "têtes de clous" en or à l'aide d'un équipement de soudure or thermosonique classique. Pour le montage, s'agissant de solidariser par paires les surépaisseurs de la puce et celles des pistes conductrices avec établissement d'un bon contact électrique, plusieurs procédés sont à disposition : le chauffage rapide de la puce associé à une pression, ce qui résulte en un brasage pour chaque paire de surépaisseurs ; ou bien l'application d'une pression associée à une vibration ultrasonore à 60 kHz induite par la presse qui supporte la puce (connue depuis longtemps pour la soudure de fils conducteurs). Un troisième procédé de connexion consiste à utiliser de la colle conductrice, par exemple une colle époxy chargée à 70 % d'argent, préalablement déposée sous forme de gouttelettes calibrées, ponctuellement, sur les surépaisseurs aux extrémités des pistes conductrices, ou sur les surépaisseurs du composant par immersion desdites surépaisseurs dans un résevoir de colle. Ces techniques, classiques, n'ont pas été représentées ni décrites pour ne pas surcharger l'exposé. Elles sont décrites notamment dans les demandes de brevet WO 92/13319 et WO 92/13320. Une colle isolante peut aussi être utilisée, qui ne nécessite pas un dépôt ponctuel sur les surépaisseurs métalliques réalisées sur les plages de métallisation du composant. Dans ce cas, une goutte de colle isolante est déposée au fond de la cavité, avant report du composant. Pendant la prépolymérisation de la colle, il est nécessaire d'appliquer une pression sur le composant pour obtenir un bon contact ohmique.

Une technique préférée de montage flip-chip, quoique plus délicate que celles indiquées au paragraphe précédent, est représentée à la figure 5. Dans ce cas, l'opération d'élaboration des surépaisseurs sur les contacts de la puce peut être économisée. Quant aux extrémités des pistes conductrices 9 sur le fond 7 du logement 5, elles peuvent toujours comporter des surépaisseurs, de préférence, et, de préférence aussi, de forme cylindrique (41, figure 4A).

La colle utilisée est une colle conductrice particulière dite anisotrope, déjà utilisée notamment pour le montage en surface de composants passifs. Ce type de colle contient des particules conductrices en faible concentration. Ces particules, élastiquement déformables, dont le diamètre est de l'ordre de 10 à 20 µm, permettent une conduction électrique lorsqu'elles sont pressées entre deux contacts, la colle restant isolante aux endroits où il n'y a pas de contacts. Des métallisations carrées de 100 µm de côté avec des espacements de 100 µm sont compatibles avec l'utilisation de ces colles en ce qui concerne l'aspect conduction (densité de particules se trouvant sur la métallisation au moment du collage -il faut en effet compter plusieurs particules, plutôt qu'une seule, qui serait théoriquement suffisante, pour l'établissement d'un bon contact-) et ne présentent pas de risque de court-circuit entre pistes conductrices. Ces colles sont actuellement disponibles sous forme de film (fabriquées par la société américaine 3M, ou la société japonaise HITACHI) ou sous forme de pâtes (fabriquées par les sociétés des Etats-Unis d'Amérique AIT et ZYMET, ou allemande LCD MIKROELECTRONIC). Des versions polymérisables au rayonnement ultraviolet sont disponibles. Pour la mise en oeuvre de l'invention, la colle anisotrope sous forme de pâte est préférée à celle sous forme de film. On notera que, pour l'utilisation de cette technique de contact, un compromis doit être trouvé entre l'établissement d'une bonne conduction électrique au niveau de chaque contact de la puce et l'absence de courts-circuits dûs à des agglomérats de particules entre pistes. A contraintes de dimensionnement des contacts égales, ce compromis est d'autant plus facile à réaliser dans la mesure où il est possible d'augmenter la concentration en particules tout en diminuant leur taille. Mais pour que cette diminution de taille soit possible, il faut arriver à obtenir une bonne planéité de l'ensemble des extrémités des pistes sur le fond 7 du logement (celle des contacts du circuit intégré étant par ailleurs acquise). Un autre élément favorable à l'absence de courts-circuits entre pistes est la précision qu'il est possible d'obtenir pour la configuration des extrémités des pistes et pour le positionnement correct du circuit intégré lors du collage : une bonne précision, sous ces deux derniers aspects, permet de rendre les extrémités de pistes plus fines et donc d'augmenter la distance entre pistes, ce qui diminue la probabilité de courts-circuits.

La figure 5 montre le détail des connexions par colle anisotrope. On a représenté le circuit intégré 4, avec ses contacts 51 et une couche de passivation superficielle entre contacts 52 ; le fond 7 du logement dans le support de carte 1, muni des extrémités de pistes 9 qui ne comportent pas de surépaisseurs en l'occurrence. Par collage, accompagné d'une certaine pression, des particules conductrices telles que 55 ont été emprisonnées dans la colle 56 puis comprimées entre les paires de contacts 9 et 51. D'autres particules, telles que 57 sont situées en dehors des contacts et ne participent à aucune conduction électrique. Pendant l'opération de collage le circuit intégré a été prépositionné de façon à ce que ses plages de métallisation (contacts) et les extrémités de pistes (avec ou sans surépaisseurs) soient en substance alignées. Une goutte de colle anisotrope a été déposée au fond du logement puis le circuit intégré a été déposé et pressé sur la colle. La polymérisation de la colle a ensuite été effectuée, soit à l'aide d'un four, soit par un système UV (dans le cas de résines réticulables aux UV).

Comme déjà décrit ci-dessus en référence à la figure 1, la cavité 5 a été ensuite remplie (non représenté) par un simple procédé de potting. La simplicité de cette opération permet l'utilisation de système remplissant plusieurs cavités à la fois et donc l'obtention de capacités de production élevées par équipement. La résine utilisée est de préférence une résine de haute pureté ionique offrant une bonne résistance à l'absorption d'humidité et protégeant efficacement la puce de circuit intégré lors des flexions et des torsions de la carte.

Il faut noter que l'emploi d'une colle pour le collage de la puce et d'une résine de protection compatibles et possédant le même mode de polymérisation (thermique ou UV) permet de réaliser les opérations de collage de la puce et le remplissage de la cavité avec le même équipement. La séquence des opérations est alors la suivante :
- collage de la puce,
- remplissage de la cavité à l'aide d'un dispenseur de résine monté sur l'amenage de l'équipement de collage,
- polymérisation simultanée de la colle du circuit intégré et de la résine d'enrobage. Dans cette éventualité, il est recommandé toutefois de prépolymériser la colle anisotrope avant son application sur le fond du logement. Dans ce cas, un seul équipement permet de réaliser l'intégralité du montage.

## Revendications

1. Procédé de fabrication et d'assemblage de carte électronique comportant un support plan électriquement isolant muni d'un logement pour recevoir un circuit intégré et, sur une face dudit support plan, de plages métalliques de contact reliées électriquement à des contacts du circuit intégré, caractérisé en ce qu'il consiste à :
- former dans ledit support un logement ouvert sur la face de celui-ci où sont définies lesdites plages métalliques de contact,
- former par une technologie dite MID en trois dimensions, des pistes électriquement conductrices s'étendant depuis ladite face dudit support jusqu'au fond dudit logement en s'étendant aussi le long des parois latérales de celui-ci, chacune desdites pistes étant reliée à une plage métallique précitée,
- mettre en place ledit circuit intégré dans ledit logement en le fixant au fond de celui-ci,
- connecter électriquement les contacts du circuit intégré aux extrémités des pistes conductrices s'étendant sur le fond dudit logement, et
- remplir ce dernier d'une résine de protection.

2. Procédé de fabrication et d'assemblage selon la revendication 1 selon lequel l'étape d'application des pistes électriquement conductrices consiste en le collage par pression à chaud des pistes munies d'une colle activable à chaud (hot foil embossing en anglais).

3. Procédé de fabrication et d'assemblage selon la revendication 1 selon lequel l'étape d'application des pistes électriquement conductrices consiste en l'application par tampographie d'un catalyseur, selon la configuration désirée pour les pistes, suivie d'une métallisation par autocatalyse.

4. Procédé de fabrication et d'assemblage selon la revendication 1 selon lequel l'étape d'application des pistes électriquement conductrices consiste en un procédé de photogravure 3D mettant en oeuvre un hologramme laser.

5. Procédé de fabrication et d'assemblage selon l'une des revendications 1 à 4, caractérisé en ce que ladite étape de réalisation des connexions électriques consiste en le collage par colle conductrice ou non conductrice du circuit intégré, par sa base, au fond dudit logement, puis la soudure de fils conducteurs entre les contacts du circuit intégré et les pistes conductrices.

6. Procédé de fabrication et d'assemblage selon l'une des revendications 1 à 4 selon lequel ledit support de carte est réalisé, avec son logement, selon une technique de moulage par injection et comporte des surépaisseurs au fond du logement aux emplacements prévus pour les extrémités desdites pistes conductrices.

7. Procédé de fabrication et d'assemblage selon l'une des revendications 1 à 4, ou 6, caractérisé en ce que ladite étape de réalisation des connexions électriques consiste en une technique de montage flip-chip du circuit intégré, lesdites connexions étant réalisées par soudure, par colle isolante, ou par colle conductrice en des points localisés, les contacts du circuit intégré étant munis de surépaisseurs.

8. Procédé de fabrication et d'assemblage selon l'une des revendications 1 à 4, ou 6, caractérisé en ce que ladite étape de réalisation des connexions électriques consiste en une technique de montage flip-chip du circuit intégré, lesdites connexions étant réalisées par collage, associé à une pression, au moyen d'une colle à conduction électrique anisotrope à l'état de film préformé ou de pâte, les contacts du circuit intégré étant démunis de surépaisseurs.

9. Procédé de fabrication et d'assemblage selon la revendication 8, caractérisé en ce que ladite colle à conduction électrique anisotrope est prépolymérisée avant l'étape de réalisation des connexions électriques et que sa polymérisation finale est simultanée à celle de ladite résine de protection.

## Claims

1. Process for the manufacture and assembly of an electronic card comprising an electrically insulating flat support provided with a housing for receiving an integrated circuit and, on one surface of the said flat support, with metal contact lugs electrically connected to contacts of the integrated circuit, characterised in that it consists in:
- forming a housing in the said support open on to the surface thereof on which the said metal contact lugs are defined;
- forming electrically conductive tracks extending from the said surface of the said support to the bottom of the said housing, also extending along the lateral walls of the latter, by means of technology referred to as three-dimensional MID, each of the said tracks being connected to an aforesaid metal lug;
- positioning the said integrated circuit in the said housing by fixing it to the bottom of the latter;
- electrically connecting the contacts of the integrated circuit to the ends of the conductive tracks extending over the bottom of the said housing, and
- filling the latter with a protective resin.

2. Manufacturing and assembly process according to claim 1, according to which the step of applying the electrically conductive tracks consists in hot-foil embossing the tracks provided with a glue activated by heat.

3. Manufacturing and assembly process according to claim 1, according to which the step of applying the electrically conductive tracks consists in applying a catalyst by a pad printing process in accordance with the desired configuration for the tracks, followed by metallisation by autocatalysis.

4. Manufacturing and assembly process according to claim 1, according to which the step of applying the electrically conductive tracks consists of a 3D photo-etching process using a laser hologram.

5. Manufacturing and assembly process according to one of claims 1 to 4, characterised in that the said step of producing the electrical connections consists in gluing the integrated circuit via its base to the bottom of the said housing by means of conductive or non-conductive glue, then in soldering conductor wires between the contacts of the integrated circuit and the conductive tracks.

6. Manufacturing and assembly process according to one of claims 1 to 4, according to which the said card support is produced, together with its housing, by an injection moulding technique and comprises reinforcements at the bottom of the housing at the locations provided for the ends of the said conductive tracks.

7. Manufacturing and assembly process according to one of claims 1 to 4 or 6, characterised in that the said step of producing the electrical connections consists of a flip-chip mounting technique for the integrated circuit, the said connections being produced by means of solder, insulating glue, or conductive glue at localised points, the contacts of the integrated circuit being provided with reinforcements.

8. Manufacturing and assembly process according to one of claims 1 to 4 or 6, characterised in that the said step of producing the electrical connections consists of a flip-chip mounting technique for the integrated circuit, the said connections being produced by gluing, associated with pressure, by means of an anisotropic electrically conductive glue in the preformed film or paste state, the reinforcements being removed from the contacts of the integrated circuit.

9. Manufacturing and assembly process according to claim 8, characterised in that the said anisotropic electrically conductive glue is prepolymerised before the step of producing the electrical connections and that its final polymerisation is effected simultaneously with that of the said protective resin.

## Patentansprüche

1. Verfahren zur Herstellung und Montage für IC-Karte, umfassend einen ebenen, elektrisch isolierenden Support, der mit einem Aufnahmeraum zur Aufnahme einer integrierten Schaltung versehen ist, und auf einer Seite des ebenen Supports metallische Kontaktbereiche, die elektrisch mit Kontakten der integrierten Schaltung verbunden sind, dadurch gekennzeichnet, daß es besteht aus:
- einem Ausbilden eines offenen Aufnahmeraums in dem Support auf der Seite desselben, wo die metallischen Kontaktbereiche definiert sind,
- einem Ausbilden durch eine MID genannte Technologie in drei Dimensionen von elektrisch leitenden Bahnen, welche sich von dieser Seite des Supports bis zum Grund bzw. Boden des Aufnahmeraums erstrecken, indem sie sich auch entlang der Seitenwände desselben erstrecken, wobei jede dieser Bahnen mit einem vorgenannten, metallischen Kontaktbereich verbunden wird,
- einem Anordnen der genannten, integrierten Schaltung in dem Aufnahmeraum, indem sie am Grund bzw. Boden desselben festgelegt wird,
- einem elektrischen Verbinden der Kontakte der integrierten Schaltung mit den Enden der Leiterbahnen, welche sich am Grund bzw. Boden des Aufnahmeraums erstrecken, und
- einem Auffüllen des letzteren mit einem Schutzharz.

2. Verfahren zur Herstellung und Montage nach Anspruch 1, gemäß welchem der Schritt des Aufbringens bzw. Anbringens der elektrisch leitenden Bahnen in dem Heißverkleben unter Druck von Bahnen, die mit einem hitzeaktivierbaren Kleber versehen sind (englisch: hot foil embossing), besteht.

3. Verfahren zur Herstellung und Montage nach Anspruch 1, gemäß welchem der Schritt des Aufbringens bzw. Anbringens der elektrisch leitenden Bahnen in dem Aufbringen durch Tampografie bzw. Abscheiden eines Katalysators gemäß der für die Bahnen gewünschten Konfiguration, gefolgt von einer Metallisierung durch Autokatalyse, durchgeführt wird.

4. Verfahren zur Herstellung und Montage nach Anspruch 1, gemäß welchem der Schritt des Aufbringens bzw. Anbringens der elektrisch leitenden Bahnen in einem 3D-Fotogravierverfahren besteht, welches einen Hologramm-Laser einsetzt.

5. Verfahren zur Herstellung und Montage nach einem der Ansprüche 1 bis 4, dadurch gekennzeichnet, daß der Schritt der Herstellung der elektrischen Verbindungen in dem Kleben mit einem leitenden oder nicht-leitenden Kleber der integrierten Schaltung über ihre Basis am Grund bzw. Boden des Aufnahmeraums und nachfolgendem Verlöten der elektrisch leitenden Drähte zwischen den Kontakten der integrierten Schaltung und den Leiterbahnen besteht.

6. Verfahren zur Herstellung und Montage nach einem der Ansprüche 1 bis 4, gemäß welchem der Support der Karte mit seinem Aufnahmeraum gemäß einer Spritzgußtechnik hergestellt wird und auf dem Grund bzw. Boden des Aufnahmeraums Überdicken bzw. Erhebungen an den für die Enden der Leiterbahnen vorgesehenen Plätzen umfaßt.

7. Verfahren zur Herstellung und Montage nach einem der Ansprüche 1 bis 4 oder 6, dadurch gekennzeichnet, daß der Schritt der Herstellung von elektrischen Verbindungen in einer Flip-Chip-Montagetechnik der integrierten Schaltung besteht, wobei die Verbindungen durch Löten durch isolierenden Kleber oder leitfähigen Kleber an lokalisierten Punkten hergestellt werden, wobei die Kontakte der integrierten Schaltung mit Überdicken bzw. Erhebungen versehen sind.

8. Verfahren zur Herstellung und Montage nach einem der Ansprüche 1 bis 4 oder 6, dadurch gekennzeichnet, daß der Schritt der Herstellung der elektrischen Verbindungen in einer Flip-Chip-Montagetechnik der integrierten Schaltung besteht, wobei die Verbindungen durch Kleben gemeinsam mit einem Druck mittels einem anisotropen, elektrisch leitenden Kleber in Form eines vorgeformten Films oder einer Paste durchgeführt wird, wobei die Kontakte der integrierten Schaltung keine Überdicken aufweisen.

9. Verfahren zur Herstellung und Montage nach Anspruch 8, dadurch gekennzeichnet, daß der anisotrope, elektrisch leitende Kleber vor dem Schritt der Herstellung der elektrischen Verbindungen präpolymerisiert wird und daß die Endpolymerisation gleichzeitig mit jener des Schutzharzes erfolgt.
